# EUROPEAN PATENT APPLICATION

(11) **EP 2 490 099 A1**
(43) Date of publication of application: **22.08.2012**
(21) Application number: 09850400.4
(22) Date of filing: 15.10.2009
(51) Int. Cl.: G06F 1/26

(54) **CIRCUIT BOARD AND ELECTRONIC DEVICE**

(71) Applicant: Fujitsu Limited, Kawasaki-shi, Kanagawa 211-8588 (JP)
(72) Inventor: ASANO, Hidehiro, Kawasaki-shi Kanagawa 211-8588 (JP); MIYAMOTO, Toshihiro, Kawasaki-shi Kanagawa 211-8588 (JP)
(74) Representative: Holz, Ulrike
(86) International application number: PCT/JP2009/067857
(87) International publication number: WO 2011/045858

(57) **Abstract**

A disclosed circuit board includes a wiring substrate, a circuit that operates with a power from a first power supply and is provided on the wiring substrate, the circuit including a degrading component that degrades by being in a non-electrified state, a second power supply provided on the wiring substrate, an electrification control part that is provided on the wiring substrate and configured to intermittently electrify at least the degrading component by using a power from the second power supply.

## Description

### FIELD

The embodiments discussed herein are related to a circuit board and an electronic device.

### BACKGROUND

Electronic devices such as computers and mobile phones have a circuit component(s) installed therein. Further, many electronic devices are installed with a circuit board that has a circuit component(s) mounted on a printed circuit board (wiring substrate).

The circuit component installed in the electronic device degrades due to various causes. Further, there are various causes that lead to the degradation of the characteristics of the circuit component. Various counter-measures are proposed in correspondence with the causes (see, for example, Patent Document 1-4).

### PATENT DOCUMENTS

Patent Document 1: Japanese Laid-Open Patent Publication No. 03-48999
Patent Document 2: Japanese Laid-Open Patent Publication No. 2005-23734
Patent Document 3: Japanese Laid-Open Patent Publication No. 07-230750
Patent Document 4: Japanese Laid-Open Patent Publication No. 10-62476

Among the circuit components having degrading characteristics, there are circuit components (e.g., an electrolytic capacitor or a flash memory) having electric characteristics that degrade when the circuit components are left unused for a long period of time such as half a year or one year. For example, in a case where a circuit board alone is stored as a reserve supply for maintenance purposes, the circuit board tends to be stored for a long period. Further, the circuit board may still be stored for a long period of time even after being installed in an electronic device. Further, in view of technological and social developments of the future, it is desired to extend the life-span of the circuit board or the electronic device including the circuit board.

Therefore, the performance of the circuit board or the electronic device including the circuit board is anticipated to degrade as the circuit components of the circuit board are degraded by being stored for a long period. Currently, there is no significant proposal of a technology that prevents the degradation of the performance of the circuit board and the electronic device by controlling the degradation of the circuit components.

In view of the above, it is an object in one aspect of the invention to provide a circuit board and an electronic device that prevents degradation of performance due to a long storage period.

### SUMMARY

According to an aspect of a basic embodiment of the invention, there is provided a circuit board and an electronic device including a wiring substrate, a circuit that operates with a power from a first power supply and is provided on the wiring substrate, the circuit including a degrading component that degrades by being left in a non-electrified state. The basic embodiment further includes a second power supply provided on the wiring substrate, an electrification control part that is provided on the wiring substrate and configured to intermittently electrify at least the degrading component by using a power from the second power supply. In a case of the electronic device of the basic embodiment, the first power supply is also included.

The object and advantages of the invention will be realized and attained by means of the elements and combinations particularly pointed out in the claims.

With the circuit board and the electronic device according to the above-described aspect of the invention, the degradation of performance due to a long storage period can be prevented.

### BRIEF DESCRIPTION OF DRAWINGS

Fig. 1 is a schematic diagram illustrating a first embodiment;
Fig. 2 is a flowchart illustrating a control operation according to the first embodiment;
Fig. 3 is a schematic diagram illustrating an example of an electrification path of an auxiliary power supply;
Fig. 4 is a flowchart illustrating an operation of an interruption process according to the first embodiment;
Fig. 5 is a schematic diagram illustrating a second embodiment;
Fig. 6 is a flowchart illustrating a control operation according to the second embodiment;
Fig. 7 is a schematic diagram illustrating a third embodiment;
Fig. 8 is a flowchart illustrating a control operation according to the third embodiment; and
Fig. 9 is a flowchart illustrating an operation of an interruption process according to the third embodiment.

### DESCRIPTION OF EMBODIMENTS

In the following, a circuit board and an electronic device according to a basic embodiment of the present invention are described with reference to the accompanying drawings.

With the basic embodiment, degradation of circuit components can be prevented by intermittently electrifying one or more degrading components. As a result, the performance of the circuit board and the electronic device can be prevented from degrading even when the circuit board and the electronic device are stored for a long period. In the following, first and second modified examples of the basic embodiment are described as preferable examples. According to the first modified example, an electrification control part includes a timer that measures elapsed time. This electrification control part includes a time-elapse electrifying part that temporarily electrifies at least a degrading component with power from a second power supply in a case where the elapsed time measured by the timer has reached a predetermined reference time. Further, the electrification control part includes a reset part that resets the timer in a case where the degradation component is electrified by both first and second power supplies.

With the first modified example, the degrading component can be electrified at periodic intervals by the electrification control part having a simple configuration including, for example, the timer.

According to the second modified example, an electrification control part includes a supply confirmation part that confirms whether power is supplied from the first power supply to a circuit. Further, the electrification control part of the second modified example includes a non-electrified-state electrifying part that temporarily electrifies at least the degrading component with power from the second power supply in a case where the supply confirmation part confirms that no power is supplied from the first power supply.

With the second modified example, the second power supply can continue to supply power for a long time because the second power supply performs no electrification in a case where power is supplied with the first power supply.

The following first embodiment described with reference to the accompanying drawings corresponds to a detailed example of the above-described basic embodiment as well as a detailed example of the above-described first and second modified examples.

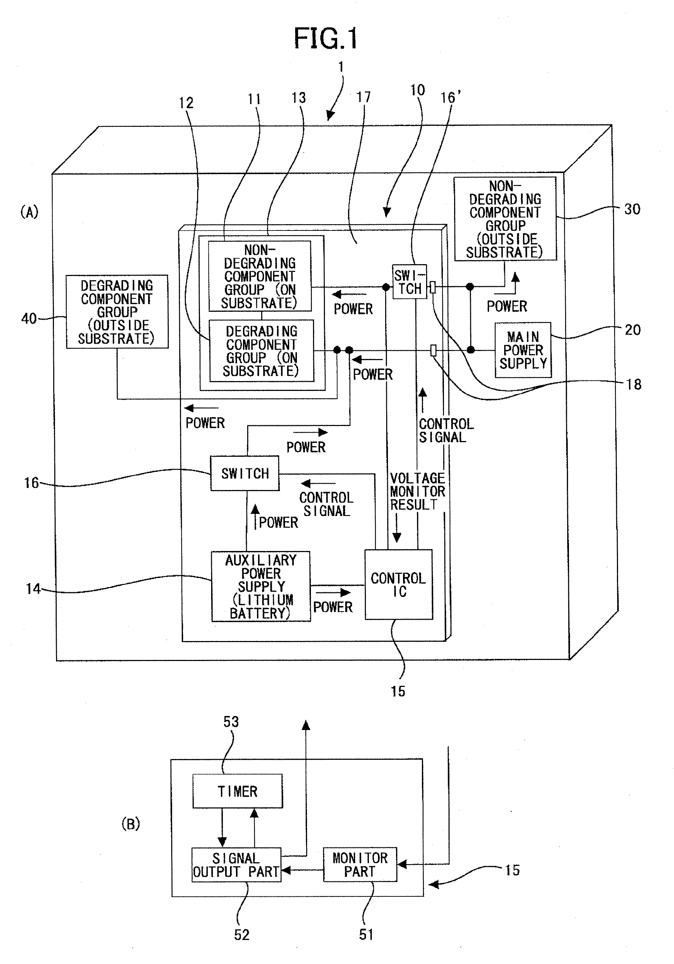

Fig. 1 is a schematic diagram illustrating the first embodiment.

The type of the electronic device 1 illustrated in part (A) of Fig. 1 is not limited in particular. The electronic device 1 may be, for example, a data processing apparatus such as a personal computer or a server, a communication device such as a communication base station or a communication terminal, or a household electronic appliance such as a television or a video machine. The electronic device 1 according to the first embodiment corresponds to the electronic device of the basic embodiment.

The electronic device 1 has a circuit board 10 and a main power supply 20 installed therein. The main power supply 20 is a constant voltage power supply that obtains power from an external alternating current (AC) power source (not illustrated) and applies a direct current voltage to the circuit board 10. The circuit board 10 includes a wiring substrate 17 and a circuit 13 provided on the wiring substrate 17. The circuit 13 includes a non-degrading component group 11 whose electric characteristic does not degrade even in a non-electrified state and a degrading component group 12

(e.g., electrolytic capacitor, flash memory) whose electric characteristic degrades in a non-electrified state. For example, in a case where a non-electrified state of an electrolytic capacitor continues for a long time, the disfiguration of an oxide film (which has a function of an electrode) causes a conductive state between the oxide film and an electrolytic substance. In a case where voltage is applied to the electrolytic capacitor in this state, a leak current is generated. In a case where the degree of degradation of an electric characteristic for a component belonging to the degrading component group 12 is small, the characteristic may recover if the component is temporarily electrified. For example, with the electrolytic capacitor, the oxide film may be reformed by the leak current generated by the electrification. Thereby, the disfiguration of the oxide film can be restored. Among the components belonging to the degrading component group 12, there is a component whose electric characteristic degrades even when electrified for a long time. For example, with the electrolytic capacitor, the property of the electrolytic substance may change when the electrolytic capacitor is electrified for a long time. Thereby, the electric characteristic of the electrolytic capacitor may degrade. In other words, although degradation occurs for the component belonging to the degrading component group 12 when not subjected to electrification, another type of degradation could occur when subjected to electrification for a long time. The electric characteristic of the component belonging to the degrading component group 12 can be maintained for a long time by appropriately repeating electrification and non-electrification.

The electric characteristic of a component belonging to the non-degrading component group 11 does not degrade even where the component belonging to the non-degrading component group 11 is in a non-electrified state for a long time. On the other hand, the electric characteristic of the component belonging to the non-degrading component group 11 may degrade when the component belonging to the non-degrading component group 11 is electrified for a long time. Therefore, in order to extend the life-span of the circuit board 10 or the electronic device 1, it is preferable to avoid electrification of the non-degrading component group 11.

It is to be noted that Fig. 1 is for merely illustrating that the non-degrading component group 11 and the degrading component group 12 are included in the circuit 13. That is, Fig. 1 is not for illustrating the positional relationship between the non-degrading component group 11 and the degrading component group 12 in the circuit 13.

Besides the circuit 13, the circuit board 10 also has an auxiliary power supply 14, a control IC 15, a switch 16, and a switch 16' provided on the wiring substrate 17. For example, a lithium battery is used as the auxiliary power supply 14. Further, a connector 18 that connects the circuit board 10 and the main power supply 20 is provided on the wiring substrate 17.

Components outside the circuit board 10 are also installed in the electronic device 10. The components outside the circuit board 10 include a non-degrading component group 30 whose electric characteristic does not degrade even in a non-electrified state and a degrading component group 40 whose electric characteristic degrades in a non-electrified state.

Here, the circuit board 10 according to the first embodiment corresponds to the circuit board of the basic embodiment. Further, the wiring substrate 17 according to the first embodiment corresponds to an example of the wiring substrate of the basic embodiment. The main power supply 20 according to the first embodiment corresponds to the first power supply of the basic embodiment. The circuit 13 on the circuit board 10 according to the first embodiment corresponds to an example of the circuit of the basic embodiment. The component belonging to the degrading component group 12 on the circuit board 10 according to the first embodiment corresponds to an example of the degrading component of the basic embodiment. The auxiliary power supply 14 according to the first embodiment corresponds to an example of the second power supply of the basic embodiment. The control IC 15, the switch 16, and the switch 16' according to the first embodiment constitute an example of the electrification control part of the basic embodiment.

The main power supply 20 is connected to the circuit board 10 by the connector 18. The main power supply 20 supplies power to the circuit 13 on the circuit board 10 with the above-described direct current voltage via the connector 18. More specifically, the main power supply 20 supplies power to both the non-degrading component group 11 and the degrading component group 12 included in the circuit 13. The circuit 13 operates with the supplied power from the main power supply 20. In a case where the electronic device 1 illustrated in Fig. 1 is a data processing apparatus, the operation of the circuit 13 corresponds to a data processing operation. In a case where the electronic device 1 illustrated in Fig. 1 is a communication device, the operation of the circuit 13 corresponds to a communications operation. In a case where the electronic device 1 illustrated in Fig. 1 is a household electronic appliance, the operation of the circuit 13 corresponds to an operation of the household electronic appliance. Further, the main power supply 20 also directly supplies power to the non-degrading component group 30 outside of the circuit board 10. Additionally, the main power supply 20 supplies power to the degrading component group 40 outside the circuit board 10 via the circuit board 10. The supply of power by the main power supply 20 is turned on and off in accordance with the user's operations of a power switch (not illustrated) or instructions from on/off signals.

The auxiliary power supply 14 on the circuit board 10 supplies power to the control IC 15. In addition, the auxiliary power supply 14 supplies power to the degrading component group 12 on the circuit board 10 and the degrading component group 40 outside the circuit board 10 via the switch 16. The components belonging to the degrading component groups 12, 40 are directly electrified with the power from the auxiliary power supply 14. It is, however, to be noted that Fig. 1 is merely for illustrating that power is supplied to the degrading component groups 12, 40. The path of power supplied to the degrading component groups 12, 40 is described in detail below.

The switches 16, 16' are controlled to switch on and off in accordance with control signals input from the control IC 15. The supply of power from the auxiliary power supply 14 to the degrading component groups 12, 40 is turned on/off by switching on/off the switches 16, 16' in accordance with the control signals. When one of the switches 16, 16' is switched on, the other of the switches 16, 16' is switched off. The switch 16', which is connected to the non-degrading component group 11, protects the non-degrading component group 11 by stopping the flow of power from the auxiliary power supply 14 to the non-degrading component group 11. The control signals from the control IC 15 are output in accordance with monitor results of the control IC 15 where the control IC 15 monitors whether power is supplied, for example, from the main power supply 20 to the circuit 13.

The part (B) of Fig. 1 is a functional block diagram of the control IC 15. In viewing the internal function of the control IC 15, the control IC 15 includes a monitor part 51, a signal output part 52, and a timer 53. Here, the timer 53 according to the first embodiment corresponds to an example of the timer of the first modified example. The signal output part 52 and the switch 16 according to the first embodiment constitute an example of the time-elapse electrifying part of the first modified example. The signal output part 52 and the monitor part 51 constitute an example of the reset part of the first modified example. Further, the monitor part 51 corresponds to an example of the supply confirmation part of the second modified example. The signal output part 52, the timer 53, and the switch 16 constitute an example of the non-electrified-state electrifying part of the second modified example.

The monitor part 51 confirms whether power is supplied from the main power supply 20 to the circuit 13 by monitoring whether direct current voltage is applied from the main power supply 20 to the circuit 13. That is, the monitor part 51 uses the voltage signals generated by the direct current voltage of the main power supply 20 as monitor signals for monitoring the supply of power by the main power supply 20. The monitor results by the monitor part 51 are reported to the signal output part 52. The timer 53 starts measuring time in accordance with an instruction from the signal output part 52. The timer 53 can measure the time elapsed from multiple start times. Then, the timer 53 reports the measured time results to the signal output part 52. The signal output part 52 outputs controls signals for switching on/off the switches 16, 16' in accordance with the monitor results of the monitor part 51 and the measured time results of the timer 53. Thus, the circuit board 10 can autonomously electrify the degrading component groups 12, 40 based on the output control signals as described below.

Next, an operation of controlling the output of control signals is described with reference to a flowchart.

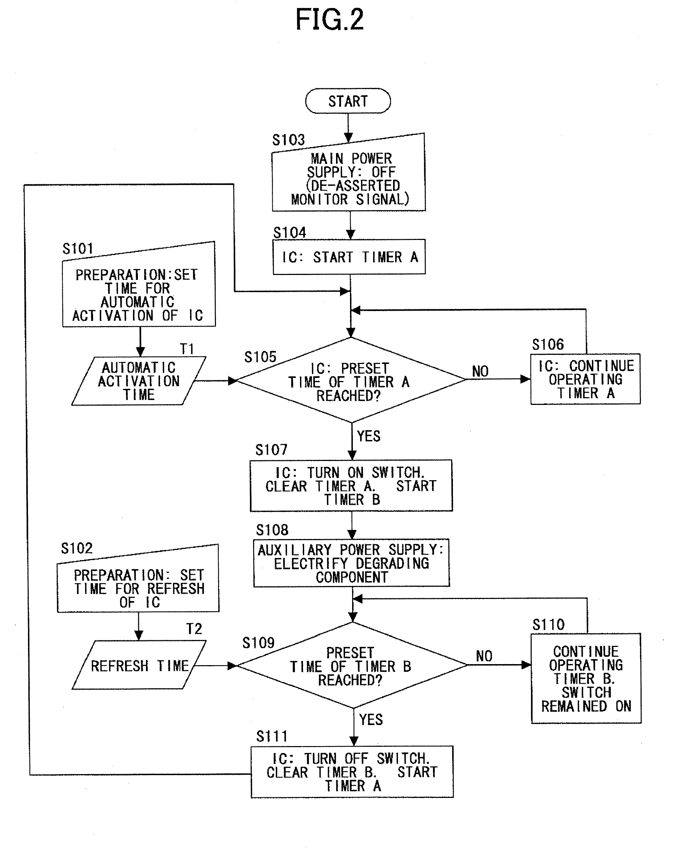

Fig. 2 is a flowchart illustrating a control operation according to the first embodiment.

In the following description, like components are denoted with like reference numerals as those of Fig. 1.

Before starting the control operation of Fig. 2, preliminary preparations are performed (Steps S101, S102). In the preliminary preparation, a setting unit (not illustrated) sets 2 concurrent times to the control IC 15. The first time is a standby time T1 for automatically activating the electrification of the degrading component groups 12, 40. The second time is a refresh time T2 for recovering the electric characteristics of the degrading component groups 12, 40 by electrification.

When the control operation of Fig. 2 is started, the monitor part 51 monitors the direct current voltage of the main power supply 20. In a case where a power switch of the main power supply 20 is turned off, a voltage signal (i.e. monitor signal), which is generated by the direct current voltage of the main power supply 20, is de-asserted (Step S103). When the monitor part 51 confirms that the monitor signal is de-asserted, the monitor part 51 reports the de-asserted monitor signal to the signal output part 52. The signal output part 52, receiving the report, instructs the timer 53 to start measuring time as a timer A for measuring the time in which the main power supply 20 is in an off state (Step S104). In a case where the time measured by the timer A has not reached the standby time T1 (No in Step S105), the signal output part 52 allows the timer 53 to continue measuring time as the timer A until the time measured by the timer A reaches the standby time T1 (Step S106). In a case where the time measured by the timer A reaches the standby time T1 (Yes in Step S105), the signal output part 52 outputs a control signal instructing the switch 16 to be switched on (Step S107). Further, in Step S107, the signal output part 52 instructs the timer 53 to stop measuring the time as the timer A and clear the measured time (i.e. reset the timer A). Further, in Step S107, the signal output part 52 instructs the timer 53 to start measuring time as a timer B for measuring the time in which the degrading component groups are electrified. When the switch 16 is switched on by the control signal, each component belonging to the degrading component group 12, 40 is directly electrified by the power from the auxiliary power supply 14 (Step S108). Next, before describing the remaining of the flowchart of Fig. 2, the path of power supplied to the degrading component groups 12, 40 is described in detail below.

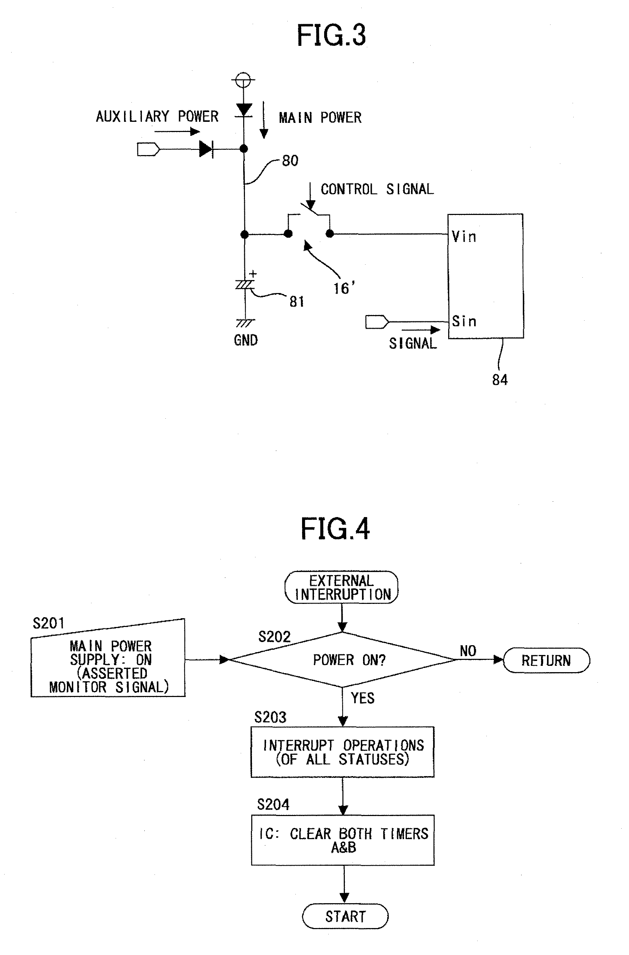

Fig. 3 is a schematic diagram illustrating an example of an electrification path by the auxiliary power supply 14.

The electrification path according to the first embodiment can be suitably applied to a suitable modified example of the basic embodiment.

In the suitable modified example, the electrification path includes a first power supply line for guiding the power of the first power supply to the circuit and a second power supply line for guiding the power of the second power supply to the degrading compound component. Further, in the suitable modified example, the electrification control part controls the on/off of the line of the second power supply. With the suitable modified example, the degrading component can be consistently electrified by the line of the second power supply.

Fig. 3 illustrates a path corresponding to that of the suitable modified example. An electrolytic capacitor 81 illustrated in Fig. 3 corresponds to a component belonging to the degrading component group 12, and a signal process component 84 illustrated in Fig. 3 corresponds to a component belonging to the non-degrading component group 11.

The power from the main power supply 20 is supplied to both the electrolytic capacitor 81 and the signal process component 84. The signal process component 84, which is operated by the power of the main power supply 20, outputs an output signal in accordance with an input signal. The electrolytic capacitor 81 is electrified by the power from the main power supply 20.

Further, the power from the auxiliary power supply 14 is also directly supplied to the electrolytic capacitor 81 by a power supply line 80. The supply of power from the auxiliary power supply 14 is turned on and off by one of the switches 16, 16' (in this embodiment, switch 16). When the supply of power from the auxiliary power supply 14 is turned on by the switch 16, the electrolytic capacitor 81 can be consistently electrified by the power from the auxiliary power supply 14. On the other hand, the other switch of the switches 16, 16' (in this embodiment, switch 16') is illustrated in Fig. 3. In a case where the power from the auxiliary power supply 14 is being supplied to the power supply line 80, the switch 16' prevents electrification of the signal process component 84 by being turned off by a control signal.

Here, the power supply line 80 in a case where the switch 16' is turned on corresponds to an example of the first power supply line of the above-described modified examples. Further, the power supply line 80 in a case where the switch 16' is turned off corresponds to an example of the second power supply line of the above-described modified examples.

In the following, the remaining of the flowchart of Fig. 2 is described.

When the electrifying by the power from the auxiliary power supply 14 is started in Step S108, the operation proceeds to Step S109. In a case where the time measured by the timer B has not reached the refresh time T2 (No in Step S109), the signal output part 52 allows the timer 53 to continue measuring time as the timer B until the time measured by the timer B reaches the refresh time T2 (Step S110). Further, in Step S110, the signal output part 52 continues to output control signals instructing the switch 16 to be switched on. Thereby, the electric characteristics of each component of the degrading component groups 12, 40 can be recovered by maintaining the electrified state of the degrading component groups 12, 40 during the period of the refresh time T2. Then, in a case where the time measured by the timer B reaches the refresh time T2 (Yes in Step S109), the signal output part 52 outputs a control signal instructing the switch 16 to be switched off (Step S111). Further, in Step S111, the signal output part 52 instructs the timer 53 to stop measuring the time as the timer B and clear the measured time (i.e. reset the timer B). Further, in Step S111, the signal output part 52 instructs the timer 53 to start measuring time as the timer A. Then, the operation returns to Step S105 and repeats the processes performed on and after Step S105.

By performing the operation illustrated in the flowchart of Fig. 2, the circuit board 10 can periodically and autonomously repeat the electrification of the degrading component groups. The periodic electrification allows each of the components belonging to the degrading component group to maintain their electric characteristics. Therefore, even in a case where the electronic device 1 is stored in an unused state for a long time, the performance of the circuit board 10 or the electronic device 10 can be maintained. Further, the periodic and autonomous electrification can be performed even in a case where the circuit board 10 is not installed in the electronic device 1 but also where the circuit board 10 alone is stored as a reserve supply for maintenance purposes. Accordingly, even in a case where the circuit board 10 alone is stored, the performance of the circuit board 10 can be maintained for a long time.

In the first embodiment, the below-described interruption process is periodically performed during the control operation illustrated in Fig. 2.

Fig. 4 is a flowchart illustrating an operation of an interruption process according to the first embodiment.

The interruption process illustrated in Fig. 4 is a process for periodically interrupting the control operation illustrated in Fig. 2. When the interruption process is started, the monitor part 51 confirms whether there is direct current voltage from the main power supply 20 (Step S202). In a case where a voltage signal (i.e. monitor signal), which is generated by the direct current voltage of the main power supply 20, is de-asserted (No in Step S202), the interruption process is terminated. After the termination, the control operation illustrated in Fig. 2 is resumed from an interrupted part of the control operation.

In a case where the power switch of the main power supply 20 is turned on during the performing of the control operation illustrated in Fig. 2, the monitor signal is asserted (Step S201). The monitor part 51 confirms that the monitor signal is in an asserted state when the interruption process illustrated in Fig. 4 is started (Yes in Step S202). Then, the control IC 15 interrupts the control operation illustrated in Fig. 2 (Step S203). More specifically, the signal output part 52 outputs a control signal instructing to switch off the switch 16. Then, in Step S204, the signal control part 52 instructs that the time measurement by the timers A and B be stopped and the time measured by the timers A and B be cleared (i.e. resetting of the timers A and B). Then, the operation of the control IC 15 returns to the start of the control operation illustrated in Fig. 2.

The interruption process illustrated in Fig. 4 serves to cancel the electrifying of the degrading component groups 12, 40 by the auxiliary power supply 14. As a result, because excess consumption of power of the auxiliary power supply 14 can be prevented, the auxiliary power supply 14 can conserve power equivalent to the power prevented from being consumed.

The description of the first embodiment is finished. Next, the second embodiment of the present invention is described. Although the second embodiment corresponds to a detailed example of the above-described first modified example, the second embodiment does not correspond to a detailed example of the above-described second modified example.

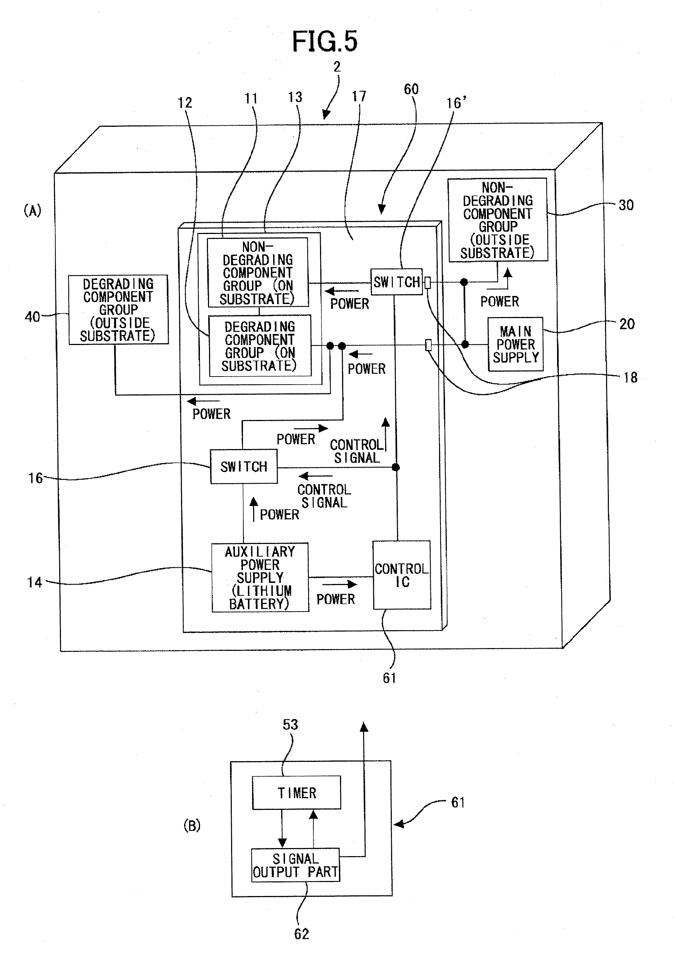

Fig. 5 is a schematic diagram of the second embodiment.

An electronic device 2 illustrated in Fig. 5 according to the second embodiment corresponds to a detailed example of the electronic device of the basic embodiment. Except for including a circuit board 60 (which is different from that of the first embodiment), the electronic device 2 of the second embodiment is substantially the same as the electronic device 1 of the first embodiment. The circuit board 60 illustrated in Fig. 5 corresponds to a detailed example of the circuit board of the basic embodiment. Except for including a control IC 61 (which is different from that of the first embodiment), the circuit board 60 of the second embodiment is substantially the same as the circuit board 10 of the first embodiment.

In the following, the second embodiment is described while focusing on the differences with respect to the first embodiment.

The control IC 61 included in the circuit board 60 illustrated in part (A) of Fig. 5, which operates with power from the auxiliary power supply 14, outputs control signals. The control signals are input to the switches 16, 16'. In other words, the targets that are controlled by the control signals are the same as those of the first embodiment. However, the control IC 61 does not monitor the direct current voltage of the main power supply 20. Therefore, the timing in which control signals are output from the control IC 61 is slightly different from the output timing of the first embodiment.

The part (B) of Fig. 5 is a functional block diagram of the control IC 61. As the internal function of the control IC 61, the control IC 61 includes the timer 53 and a signal output part as illustrated in the functional block diagram. However, unlike the first embodiment, the control IC 61 does not have a monitor part. In the second embodiment illustrated in Fig. 5, the control IC 61 controls the auxiliary power supply 14 to always electrify the degrading component group 12 at periodic intervals.

Here, the timer 53 according to the second embodiment corresponds to an example of the timer of the first modified example. The signal output part 62 and the switches 16, 16' according to the second embodiment constitute an example of the elapsed-time electrification part of the first modified example. The signal output part 62 according to the second embodiment corresponds to an example of the reset part of the first modified example.

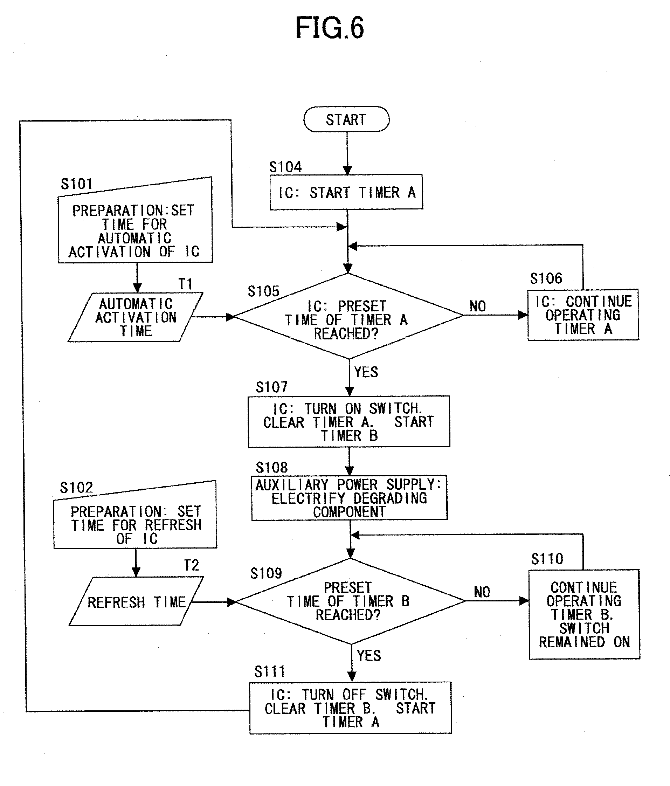

Fig. 6 is a flowchart illustrating a control operation according to the second embodiment of the present invention.

Except for lacking Step S103, the flowchart illustrated in Fig. 6 is substantially the same as the flowchart illustrated in Fig. 2.

The control operation according to the flowchart illustrated in Fig. 6 is started when the auxiliary power supply 14 (lithium battery) is installed in the circuit board 60 and supplies power to the control IC 61. Further, the interruption process for interrupting the control operation is not performed in the control operation according to the second embodiment of Fig. 6. Therefore, with the second embodiment, as long as there is power remaining in the auxiliary power supply 14, the auxiliary power supply 14 always electrifies the degrading component group 12 at periodic intervals regardless of whether power is being supplied from the main power supply 20.

The circuit board 60 according to the second embodiment also periodically and autonomously repeats the electrification of the degrading component group. Therefore, even in a case where the electronic device 1 is stored in an unused state for a long time, the performance of the circuit board 10 or the electronic device 10 can be maintained.

Next, a third embodiment of the present invention is described. The third embodiment also corresponds to a detailed example of the basic embodiment. Further, the third embodiment also corresponds to a detailed example of the first and the second modified examples. Additionally, the third embodiment also corresponds to a detailed example of the following third modified example of the basic embodiment.

In the third modified example, the second power supply is a common power supply that also acts as the first power supply. Further, the third modified example also includes a power supply line that guides the power of the common power supply to the circuit and a switch that turns the power supply line on and off in accordance with a command from outside the wiring substrate.

The third modified example is a type of embodiment in which the power for operating the circuit on the circuit board is supplied from the circuit board itself. With the third modified example, the degrading of the performance of the circuit board can be prevented for a long period by using the self-supplied power of the circuit board for the first power supply and for the second power supply, respectively.

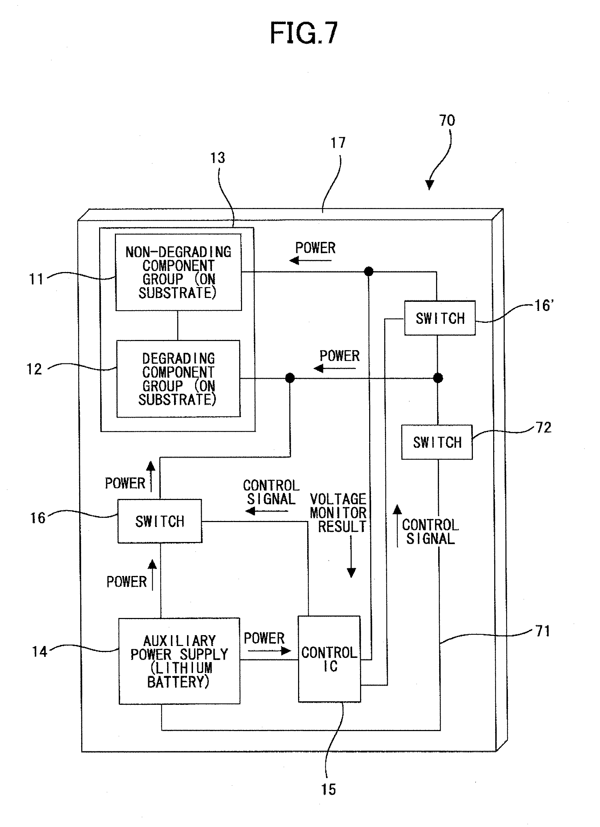

Fig. 7 is a schematic diagram illustrating the third embodiment.

A circuit board 70 (illustrated in Fig. 7) alone functions as an electronic device. The circuit board 70 corresponds to a detailed example of the circuit board of the basic embodiment as well as the electronic device of the basic embodiment.

Among the components included in the circuit board 70, like components are denoted with like reference numerals of the circuit board 10 illustrated in Fig. 1.

The circuit board 70 includes a power supply 14. Although the power supply 14 is the same as the lithium battery serving as the auxiliary power supply 14 of the Fig. 1, it is simply referred to as "power supply" in the third embodiment.

The circuit board 70 includes a power supply line 71 that guides the power from the power supply 14 to the circuit 13. Further, the circuit board 70 includes a power supply switch 72 for turning the power supply line 71 on and off in accordance with a command from outside of the circuit board 70. The "command" is not to be limited in particular. For example, the command may be an input of a control signal for turning the power supply switch 72 on and off or a manual operation by the user.

Except for the power supply 14 acting as both the main power supply 20 and the auxiliary power supply 14, the circuit board 70 according to the third embodiment is substantially the same as the circuit board 10 of the first embodiment. Therefore, as described below, the control operation and the interruption process by the control IC 15 of the third embodiment are substantially the same as those of the first embodiment.

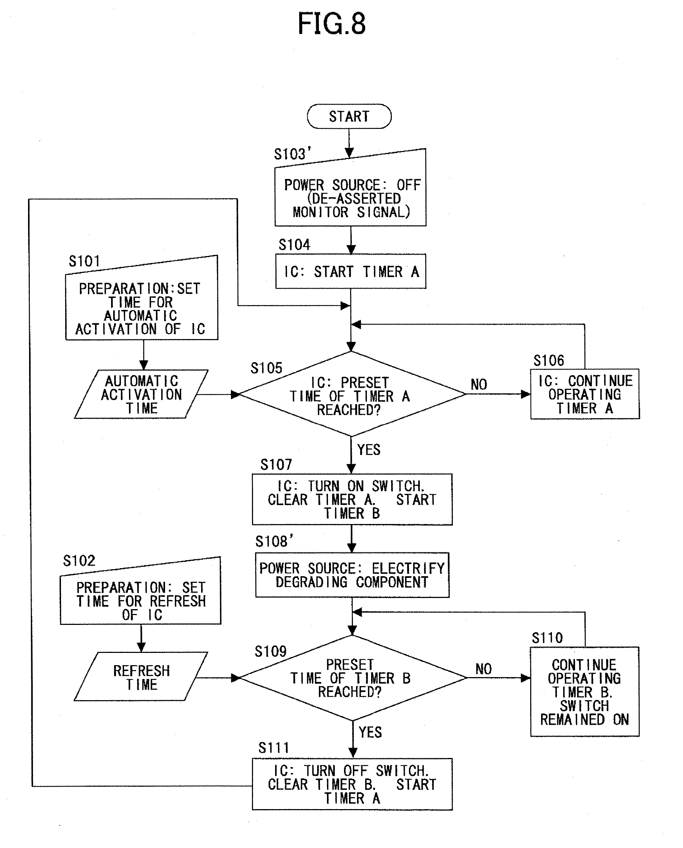

Fig. 8 is a flowchart illustrating a control operation according to the third embodiment.

In the flowchart illustrated in Fig. 8, the monitor signal is de-asserted in a case where the power supply switch 72 turns off the voltage applied from the only single power supply 14 (illustrated in Fig. 7) to the circuit 13 via the power supply line 71 (Step S103'). Further, in a case where the switch 16 is turned on in Step S107, the degrading component group 12 is electrified by the power from the only single power supply 14 (illustrated in Fig. 7) (Step S108'). Except for the Steps S103' and S108', the steps of Fig. 7 are substantially the same as those of Fig. 2. Further, regarding the overall control operation, the control operation illustrated in Fig. 8 is substantially the same as the control operation illustrated in the flowchart of Fig. 2.

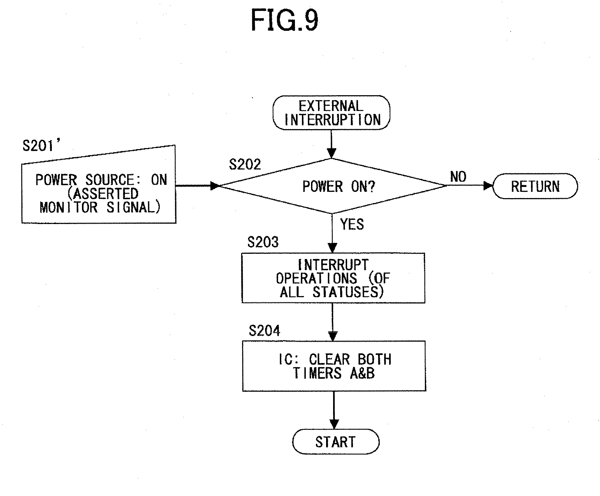

Fig. 9 is a flowchart illustrating an operation of an interruption process according to the third embodiment.

In the flowchart illustrated in Fig. 9, the monitor signal is asserted when the power supply switch 72 of Fig. 7 is turned on (Step S201'). Except for the Step S201', the steps of Fig. 9 are substantially the same as those of Fig. 4. Further, regarding the overall operation of the interruption process, the interruption process illustrated in Fig. 9 is substantially the same as the interruption process illustrated in the flowchart of Fig. 4.

With the circuit board 70 of the third embodiment, the self-supplied power of the circuit board 70 can be saved while maintaining the performance of the circuit board 70 for a long period.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. A circuit board **characterized by** comprising:
a wiring substrate;
a circuit that operates with a power from a first power supply and is provided on the wiring substrate, the circuit including a degrading component that degrades by being left in a non-electrified state;
a second power supply provided on the wiring substrate;
an electrification control part that is provided on the wiring substrate and configured to intermittently electrify at least the degrading component by using a power from the second power supply.

2. The circuit board as claimed in claim 1, **characterized in that** the electrification control part includes
a timer configured to measure an elapsed time,
an elapsed-time electrification part configured to temporarily electrify at least the degrading component with the power from the second power supply in a case where the elapsed time measured by the timer reaches a predetermined reference time, and
a reset part configured to reset the timer in a case where the degrading component is electrified by the first power supply or the second power supply.

3. The circuit board as claimed in claim 1 or claim 2, **characterized in that** the electrification control part includes
a supply confirmation part configured to confirm whether the power from the first power source is supplied to the circuit, and
a non-electrified-state electrifying part configured to temporarily electrify at least the degrading component with the power from the second power supply in a case where the supply confirmation part confirms that no power from the first power source is supplied.

4. The circuit board as claimed in one of claims 1 to 3,
**characterized in that** the second power supply includes a shared power supply acting as the first power supply,
further comprising:
a power supply line configured to guide a power from the shared power supply to the circuit, and
a switch configured to turn the power supply line on and off in accordance with a command from an outside of the wiring substrate.

5. The circuit board as claimed in one of claims 1 to 4, **characterized by** further comprising:
a first power supply line configured to guide the power from the first power supply to the circuit; and
a second power supply line configured to guide the power from the second power supply to the degrading component;
wherein the electrification control part is configured to control the turning on and off of the second power supply line.

6. An electronic device **characterized by** comprising:
a first power supply that is turned on and off;
a wiring substrate;
a circuit that operates with a power from the first power supply and is provided on the wiring substrate, the circuit including a degrading component that degrades by being left in a non-electrified state;
a second power supply provided on the wiring substrate;
an electrification control part that is provided on the wiring substrate and configured to intermittently electrify at least the degrading component by using a power from the second power supply.

7. The electronic device as claimed in claim 6, **characterized in that** the electrification control part includes
a timer configured to measure an elapsed time,
an elapsed-time electrification part configured to temporarily electrify at least the degrading component with the power from the second power supply in a case where the elapsed time measured by the timer reaches a predetermined reference time, and
a reset part configured to reset the timer in a case where the degrading component is electrified by the first power supply or the second power supply.

8. The electronic device as claimed in claim 6 or claim 7, **characterized in that** the electrification control part includes
a supply confirmation part configured to confirm whether the power from the first power source is supplied to the circuit, and
a non-electrified-state electrifying part configured to temporarily electrify at least the degrading component with the power from the second power supply in a case where the supply confirmation part confirms that no power from the first power source is supplied.

9. The electronic device as claimed in one of claims 6 to 8, **characterized in that** the second power supply includes a shared power supply acting as the first power supply,
further comprising:
a power supply line configured to guide a power from the shared power supply to the circuit, and
a switch configured to turn the power supply line on and off in accordance with a command from an outside of the wiring substrate.

10. The electronic device as claimed in one of claims 6 to 9, **characterized by** further comprising:
a first power supply line configured to guide the power from the first power supply to the circuit; and
a second power supply line configured to guide the power from the second power supply to the degrading component;
wherein the electrification control part is configured to control the turning on and off of the second power supply line.

11. The electronic device as claimed in one of claims 6 to 10, **characterized by** further comprising:
an outside degrading component that is provided outside the wiring substrate and degrades by being in a non-electrified state,
wherein the outside degrading component is electrified by the power from the second power supply along with the electrifying of the degrading component with the power from the second power supply.
